# EUROPEAN PATENT SPECIFICATION

(11) **EP 2 227 836 B1**
(45) Date of publication and mention of the grant of the patent: **18.09.2013**
(21) Application number: 07872075.2
(22) Date of filing: 28.12.2007
(51) Int. Cl.: H01L 51/42, H01L 51/05

(54) **HYBRID NANOCOMPOSITE**
NANOKOMPOSIT-HYBRIDMATERIAL
NANOCOMPOSITE HYBRIDE

(43) Date of publication of application: 15.09.2010
(73) Proprietor: Université d'Aix-Marseille, 13284 Marseille Cedex 07 (FR); Centre National de la Recherche Scientifique (CNRS), 75016 Paris (FR)
(72) Inventor: ACKERMANN, Jörg, F-13009 Marseille (FR); FAGES, Frédéric, F-83110 Sanary/Mer (FR); MARTINI, Cyril, F-13007 Marseille (FR)
(74) Representative: Blot, Philippe Robert Emile
(86) International application number: PCT/IB2007/004465
(87) International publication number: WO 2009/083748

(56) References cited:
- WO-A-2005/017957
- FR-A- 2 873 492
- US-A1- 2002 139 688
- OLSON ET AL: "Hybrid photovoltaic devices of polymer and ZnO nanofiber composites" THIN SOLID FILMS, ELSEVIER-SEQUOIA S.A. LAUSANNE, CH, vol. 496, no. 1, 1 February 2006 (2006-02-01), pages 26-29, XP005181420 ISSN: 0040-6090
- JAYADEVAN K P ET AL: "One-dimensional semiconductor nanostructures as absorber layers in solar cells" JOURNAL OF NANOSCIENCE AND NANOTECHNOLOGY, AMERICAN SCIENTIFIC PUBLISHERS, US, vol. 5, no. 11, 1 November 2005 (2005-11-01), pages 1768-1784, XP008080777 ISSN: 1533-4880
- YOSHIDA T ET AL: "ELECTROCHEMICAL SELF-ASSEMBLY OF DYE-MODIFIED ZINC OXIDE THIN FILMS" ADVANCED MATERIALS, WILEY VCH, WEINHEIM, DE, vol. 12, no. 16, 16 August 2000 (2000-08-16), pages 1219-1222, XP000963592 ISSN: 0935-9648
- YOUNG-GI KIM ET AL: "Efficient light harvesting polymers for nanocrystalline TiO2 photovoltaic cells" NANO LETTERS AMERICAN CHEM. SOC USA, vol. 3, no. 4, April 2003 (2003-04), pages 523-525, XP002494265 ISSN: 1530-6984
- VIDELOT-ACKERMANN ET AL: "Environmentally stable organic thin-films transistors: Terminal styryl vs central divinyl benzene building blocks for p-type oligothiophene semiconductors" ORGANIC ELECTRONICS, ELSEVIER, AMSTERDAM, NL, vol. 7, no. 6, 18 November 2006 (2006-11-18), pages 465-473, XP005773052 ISSN: 1566-1199

## Description

### [Field of the invention]

The present invention concerns hybrid nanocomposites, their process of manufacture and their applications, in particular for solar cell components and switchable electric devices.

### [Background of the invention]

Solar energy is presently still a fairly uncompetitive alternative to other means of energy production. The major reasons for this are the high production costs of the present silicon solar cells and the limited efficiency of low cost alternatives.

Research for improved devices has led to numerous approaches, including notably coaxial silicon nanowires (Lieber et al., Nature Lett., 449, (2007) 885). The nanowires consist of a p-doped silicon core nanowire capped with an intrinsic and n-doped silicon shell. However, silicon based devices are expensive due to material cost and the fabrication costs, which implies high temperature, high vacuum and numerous lithographic steps.

It has been proposed to replace silicon by organic or polymeric semiconductors which may be processed from a solution. However, photoexcitation in these materials does not directly result in free charge carriers, but creates electron-hole pairs called excitons. The excitons require an interface of electron-donor (n-type) and electron-receptor (p-type) material to be separated into free charge carriers. In view of their short lifetime, only excitons generated close to an interface give rise to charges. The n-type and p-type domains should thus have a large interface, while on the same time form two continuous domains in order to ensure that the charges generated reach the electrodes.

Nanocomposites are thus interesting candidates for low cost solar cells.

Solar cells based on polymer blends containing an electron-donor and an electron-acceptor phase were proposed in which polymer- fullerene blends are the most successful (Yu, G.; Gao, J.; Hummelen, J. C.; Wudl, F.; Heeger, A. J. Science 1995, 270, 1789.; Shaheen, S. E.; Brabec, C. J.; Padinger, F.; Fromherz, T.;
Hummelen, J. C.; Sariciftci, N. S. Appl. Phys. Lett. 2001, 78, 841.; Wienk, M. M.; Kroon, J. M.; Verhees, W. J. H.; Knol, J.; Hummelen, J. C.; Van Hal, P. A.; Janssen, R. A. J. Angew. Chem., Int. Ed. 2003, 42, 3371. Schilinsky, P.; Waldauf, C.; Brabec, C. J. Appl. Phys. Lett. 2002,81, 3885. Svensson, M.; Zhang, F.; Veenstra, S. C.; Verhees, W. J. H.;Hummelen, J. C.; Kroon, J. M.; Ingana..s, O.; Andersson, M. R. AdV. Mater. 2003, 15, 988.) The two polymers form an interpenetrating network with nanoscale phase separation, which leads to an highly efficient bulk heterojunction. Such organic solar cells may show a solar energy conversion efficiency of up to 5%. However, the blending of two polymers often entails problems of controlling blend morphology and stabilization of phase separation between both polymers. Furthermore electron transport and atmospherical stability of organic n-type semiconductors is weak.

Recently, conjugated polymers were blended with inorganic n-type semiconductor nanoparticles, such as hybrid solar cells combining CdSe nanorods with a poly-3(hexylthiophene) (P3HT) (Alivisatos et al., Science, 295 (2002) 2425), that may be prepared by solution processing. The use of elongated nanoparticles instead of nanospheres could improve device performance, because the nanorods and P3HT have complementary absorption spectra, and the photocurrent spectrum the resulting nanorod-polymer blend device could be extended up to 720 nm. In another example of hybrid nanocomposite solar cells, ZnO nanoparticles as the electron acceptor were blended with a conjugated polymer matrix poly[2-methoxy-5-(3¢,7¢-dimethyloctyloxy)-1,4-phenylenevinylene] (MDMO-PPV) as electron donor. (Janssen et al., J. Phys. Chem. B, 2005, 109, 9505). Solar cells prepared with ZnO nanorods instead of nanospheres did not lead to improvement in solar cell performance. The need of surfactant to increase solubility of nanorods finally results in no improvement of the solar cell performances compared to polymer blends.

Another limitation of hybrid or polymer nanocomposites is the fact that the reference polymer P3HT absorbs mainly between 300 and 650 nm and thus cannot capture a large part of the solar spectrum. The modification of the polymer proves difficult since any change in molecular structure affects other properties such as morphology, charge carrier mobility between polymer chains, the dispersion, or purity.

US 2002/139688 A1 (OKURA HIROSHI [JP] ET AL) discloses a dye sensitized solar cell, based on ZnO acicular crystals, which are covered by a Eosin Y dye covalently linked via carboxylic acid groups to the ZnO surface.

### [Summary of the invention]

The purpose of the present invention was thus to provide a novel nanocomposite material, in particular for low cost solar cells with high efficiency, that would overcome one or more of the previously stated drawbacks.

This purpose is met by providing a hybrid nanocomposite comprising elongated inorganic nanoparticles, in particular nanorods, grafted on at least part of their surface with an electrically conducting organic compound, as defined in claim 1.

These materials exhibit interesting properties, in particular with regard to charge carrier transport, since they allow for independent coaxial ambipolar charge carrier transport inside the inorganic and organic part of the hybrid nanocomposite, Furtermore the materials allows a straight forward tuning of their absorption, organisation and solubility.

### [Definitions]

In the following, it is meant by:
Elongated nanocrystals : crystalline, in particular monocristalline nanostructures comprising at least one elongated moiety, such as nanowires, nanorods, nanotubes, nanobipods, nanotripods, nanotetrapods or nanomultipods such as nanostars. For nanowires, nanorods and nanotubles, the elongated moiety constitutes the whole nanostructure. The aspect ratio of the elongated moiety is generally more than 2, preferably more than 3, and most preferably comprised between 5 and 200. Typical dimensions of the elongated moiety are a diameter of 3-100 nm and a length of 10-2000 nm.
Nanocomposite : a material comprising at least two finely dispersed non miscible components, the dimension of the dispersed phase being in the nanoscale, and typically ranging from 1 to 500 nm, preferably from 2 to 100 nm.
Hybrid: comprising an inorganic component and an organic component.
Organic compounds : Compounds consisting mainly of carbon and hydrogen and containing to a lower extent other elements such as oxygen, nitrogen, sulfur and phosphorus, except elemental carbon, carbonates, carbon oxide and carbon cyanide.
Grafting : process of linking molecules onto a solid surface, involving electrostatic interaction, adsorption and/or covalent binding.
Self-assembled monolayer : ordered molecular assembly formed by adsorption of a single layer of molecules onto a solid surface.
Electrical conductor : material allowing for charge carrier transport, including metallic conductors and semiconductors.

### [Detailed description]

### [Nanocomposite]

According to a first aspect, the invention concerns a hybrid nanocomposite material comprising electrically conducting inorganic elongated nanocrystals grafted on at least part of the surface thereof with an electrically conducting organic compound.

The hybrid nanocomposite according to the invention comprises elongated nanocrystals as main or exclusive inorganic components.

The anisotropic geometry of the elongated nanocrystals ensures an easy, directed charge carrier transport along their long axis since they require much less hopping steps to reach the electrode of a device such as a solar cell compared to spherical nanocrystals.

Advantageously, the nanocrystals have a preferred orientation in the nanocomposite. Such a preferred orientation may be obtained in particular by intermolecular forces given by surfactants (surface effects) or by application of an electrical field. A well-ordered assembly of elongated nanocrystals improves interconnection between the nanocrystals and allows charge carrier transport over large distances with high efficiency. The use of inorganic material is further advantageous in that these materials exhibit high charge mobility and dimensional and environmental stability.

The hybrid nanocomposite according to the invention comprises electrically conducting inorganic elongated nanocrystals. The elongated nanocrystals may be in particular semiconductors or metals. Most often, the nanocrystals will be n-type or p-type semiconductors, depending on the conception of the device.

Such nanocrystals may be made of a large collection of inorganic compounds, including in particular: titanium, zirconium, hafnium, vanadium, niobium, tantalum, chromium, molybdenum, tungsten, manganese, technetium, rhenium, iron, osmium, cobalt, nickel, copper, silver, gold, zinc, cadmium, scandium, yttrium, lanthanum, boron, gallium, indium, arsenic, thallium, silicon, germanium, tin, lead, magnesium, calcium, strontium, barium and aluminum, and the simple or mixed chalcogenides, in particular oxides and sulfides, thereof. The semiconductors may be elemental materials such as silicon and germanium, eventually doped, or compound semiconductors such as gallium arsenide and indium phosphide, or alloys such as silicon germanium or aluminium gallium arsenide.

Preferred metal conductors are those having high charge carrier mobility such as gold, silver, copper and indium doped tin oxide (ITO).

Preferred semiconductors have a band gap between 0,4 eV and 4,1 eV, particularly a band gap close the solar spectrum. The band gap may then further be tuned by varying the diameter of the elongated nanocrystal or by additional doping. Particularly preferred semi-conductors are zinc oxide, zinc sulfide and titanium dioxide.

Zinc oxide is a particularly preferred semi-conductor. It is an n-type semiconductor which combines a number of advantageous properties: it is cheap, has high charge carrier mobility, is transparent and non toxic and zinc oxide nanorods are easily accessible (Weller et al., Angew. Chem. Int. Ed., 41(7), (2002) 1188).

The elongated nanocrystals are preferably monocrystals. Indeed, monocrystals show improved transport properties and the absence of surface defects improves the ability of grafted organic monolayer to form highly crystalline SAM.

The hybrid nanocomposite according to the invention further comprises organic compounds grafted onto the elongated nanocrystals as main or exclusive organic components.

According to the invention, the electrically conducting organic compounds are preferably p-type or n-type semiconductors. They may also be metallic conducting organic compounds such as poly(3,4-ethylenedioxythiophene) (PEDOT).

The surface of the elongated nanocrystal comprises a large cylindrical segment which has a reasonable curvature and thus allows for the formation of an auto-assembled monolayer (SAM) around the nanocrystal. Therefore, although this feature is not essential to the invention, the organic compound preferably forms a SAM grafted onto the nanocrystals in the composite of the invention. In some cases, the ordered molecules in the SAM can even be crystalline, as observed by X-ray diffractometry.

Although grafting through pure electrostatic interaction is not excluded, the presence of stronger bonds such as covalent bonds is expected to improve the stability of the composites and is thus preferred. The organic compounds thus preferably comprise at least one anchoring moiety appropriate to form a covalent bond with the inorganic nanocrystal surface. However, in order to favor formation of a crystalline SAM, it is preferred that the grafting bond be moderately strong, which allows a reversible bonding and thus positional adjustments. Furthermore, while ensuring efficient adsorption of the organic compound on the nanocrystal surface, the anchoring moiety may further also promote efficient electronic coupling between the donor level of the organic compound and the acceptor level of the nanocrystal.

The electrically conducting organic compounds are defined by formula (I):

A-L-Y-Z-X (I)

wherein :
A is an anchoring moiety, and may be in particular a carboxylic acid, an amine, a phosphonic acid, a phosphate, a thiol or a silane group ;
L is a non conducting moiety and may be in particular a saturated hydrocarbon group, in particular a saturated, straight or branched, alkyl group with 3 to 20 carbon atoms, or may be absent;
Y is an electrically conducting moiety comprising a conjugated system capable of n- or p-type semiconduction such as pentacene, anthracene, phtalocyanines, porphyrines, fullerenes, oligothiophenes, polypyrrol, carotene, chlorophylls, bacterio-chlorophylls and carotenoids or organic metals such as functionalized carbon nanotubes, PEDOT, charge transfer complexes such as (BEDT-TTF)₂I₃
Z is a solubilizing moiety and may in particular be an unconjugated hydrocarbon group such as a straight or branched, saturated or unsaturated alkyl group with 1 to 20 carbon atoms, in particular n-butyl, n-pentyl, n-hexyl, n-heptyl and n-octyl, or may be absent; and
X is a stabilizing moiety capable of forming intermolecular bonds and may in particular be a group forming hydrogen bonds such as hydroxy, amino, amide or carboxylic acid, or may be absent.

In order to be grafted to the nanocrystals, the organic compound of formula (I) has one or more anchoring moieties A capable of forming a bond to the surface. Preferably, the bond formed by the anchoring moiety allows for a displacement (or a desorption - readsorption cycle) at the surface advantageous for the crystallization process.

The organic compound of formula (I) further comprises a electrically conducting moiety Y allowing for charge carrier transport, light absorption and exciton generation. The moiety may be monomeric, oligomeric or polymeric. Preferably, the compound contains a pi-conjugated system, in particular derived from compounds such as pentacene, anthracene, , oligothiophenes and polythiophenes such as poly-3(hexylthiophene) (P3HT), poly-(3,4-ethylenedioxythiophene) (PEDOT) and polypyrrol, or non pi-conjugated systems such as fullerenes, phtalocyanines, porphyrines. Other preferred moieties are derived from naturally occurring conjugated compounds with photoactive, conductive properties originating from biomass which can be obtained from extraction of natural systems, such as plants, algae, photosynthetic bacteria, such as chlorophylls, bacterio-chlorophylls and carotenoids.

Preferably, the organic compound has a LUMO and HOMO level position compared to the valence and conducting band of the inorganic nanocrystal such as to allow efficient exciton dissociation at the hybrid interface by a pronounced band offset. This band offset can be improved by adapting the Fermi level of the inorganic nanocrystal by intentional doping.

Specially preferred are conjugated systems absorbing in the solar spectrum. Further preferred are aromatic moieties that are capable of pi-orbital overlap and thereby contribute to stabilize the organic shell.

The organic compound of formula (I) may further optionally contain a non conducting moiety L between the anchoring moiety A and the conducting moiety Y. Such a non conducting moiety may be a saturated hydrocarbon group, in particular a saturated, straight or branched, alkyl group with 3 to 20 carbon atoms.

According to a preferred embodiment, the organic compound of formula (I) may further contain a solubilizing moiety Z capable of enhancing the solubility of the grafted nanocomposite within the grafting solution. This ensures a further exchange with the molecules in solution, and thereby favors the formation of a crystalline monolayer.

The organic compound of formula (I) further may optionally contain a stabilization moiety X capable of stabilizing the molecule aggregates at the surfaces of the nanocrystals by intermolecular interaction. Such moieties allow dense grafting and thus promote a crystalline monolayer. Such moieties may be in particular groups such as hydroxy, amino, amide or carboxylic acid. Particularly preferred are amide groups and moieties derived from alpha-amino acids, oligopeptides, urea, nucleosides, cholesterol and trialkylbenzene.

The formation of gels may be interesting to produce networks of fibers, which allows the structuration and orientation of the nanocrystals and the conjugated organic compounds, leading to anisotropic charge transport. Gel formation also allows a control of the viscosity of solutions, which is an important parameter for solution-based deposition.

The organic compounds of formula (I) linked to the inorganic nanocrystals may confer self-assembling properties to the nanostructure.

Therefore, the organic compound may be chosen such that the formation of an ordered monolayer at the surface of the elongated nanocrystals may be promoted or on the contrary suppressed.

In particular, the presence of a destabilizing terminal group, in particular a sterically hindered group, is a convenient means to avoid the ordering of the grafted molecules at the surface of the nanocrystal and to obtain an amorphous SAM.

The organic compound are preferably non-symmetrically substituted molecules with three different functionalities, i.e. a linking moiety, a conducting moiety and a self-assembling moiety.

In a simple embodiment, the organic compounds may be a carboxylic acid having 3 to 10 carbon atoms linked to a pi-conjugated system substituted by one or more hydrogen-bond forming groups such as amide groups. The carboxylic acid group will bond to the nanocrystal surface, while the terminal amide groups will form intermolecular hydrogen bonds.

An example of such organic compounds are the compounds of formula (II) derived from oligothiophene : 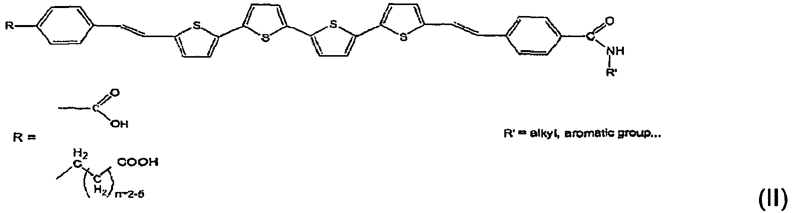 wherein:
R is an anchoring moiety, in particular a carboxy acid with 3 to 6 carbon atoms further to the carboxy acid group; and
R' is a straight, branched or cyclic hydrocarbon group, in particular an alkyl or aromatic group with 1 to 20 carbon atoms.

A self-assembling effect can also be obtained by grafting two or more different compounds on the surface of the nanocrystal. For such as mixed monolayer, one organic compound has electrical conducting properties and not necessarily self-assembling properties while the second or others compounds may have only self-assembling properties without any conducting properties.

The orientational order of the nanocrystals within the nanocomposite may be increased by using organic compounds with anchoring moiety with liquid crystal (LC) behaviour.

Particularly preferred organic compounds are the following:

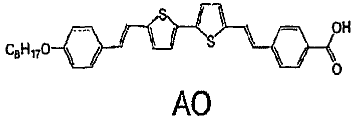

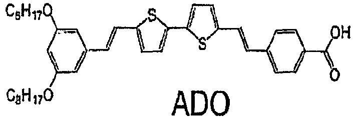

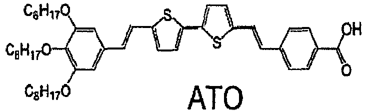

A liquid crystal behaviour can also be obtained by multiple grafting two or more different organic compounds on the surface of the nanocrystal. For such a mixed monolayer, one compound has electrical conducting properties and not necessarily LC properties while the second or others compound may further bear one or more LC forming groups.

Nanocrystals grafted with organic compounds as described produce hybrid nanocomposite containing parallel channels for ambipolar coaxial charge carrier transport.

Particularly preferred are materials with tunable absorption and transport properties that allow the preparation of solar cells absorbing in a specific wavelength region.

In order to produce efficient solar cells, the absorption spectrum of the organic compound is preferably close to or within the solar spectrum. Usually this is not obtained with a single species. However, grafting multiple species with complementary absorption spectra may lead to a « black » nanocomposite which is capable to absorb over the whole solar spectrum. Particularly preferred is the combined grafting of pentacene or oligothiophenes with phtalocyanines, which leads to an absorption spectrum going from 300 nm to 900 nm.

Nanocomposites with multiple grafting may be obtained by grafting different species, simultaneously or subsequently, on one batch of nanoparticles or by mixing different batches of nanoparticles grafted with one species of organic semiconductor.

Once grafted, the organic compounds form around the nanocrystal a well-defined and stable domain with adjustable absorbing and conducting properties. A nanocomposite comprising inorganic n- or p-type semiconductor nanocrystals grafted with organic p- or n-type semiconductor compounds, respectively, allows for coaxial ambipolar conduction, the electron being mainly transported in the nanocrystal while the holes are mainly transported in the organic shell.

The organic compounds are grafted on at least part of the surface of the elongated nanocrystals. In most cases, the grafting of a complete monolayer is preferred in order to support the formation of a well-ordered or crystalline SAM.

However, for some cases, hybrid nanocomposite with an incomplete SAM may be preferred.

Indeed, hybrid nanocomposites with incomplete or mixed SAM may facilitate the conduction between the hybrid nanocrystals. This is because the charge carrier transport between two neighboring hybrid nanocrystals involves the crossing of two SAM, which, for a n-p configuration are equivalent to an n-p-p-n junction. The probability that an electron crosses such a junction efficiently, i.e. without resistance loss, may be improved if a certain amount of organic compound with a different conduction type is grafted onto the nanocrystal as explained above or if direct mechanical contact between nanocrystal surface is possible.

The result is the generation of "transport channels" for electrons, which eases the charge carrier transport across the nanocrystals.

Grafting of an electrical conducting organic compounds on the surface of electrical conducting inorganic elongated nanocrystals yields hybrid nanocomposites that may form the following intra-nanoparticle junctions :
- hybrid nanocomposites comprising metallic nanocrystals grafted with an organic compound with p-type or n-type charge carrier transport properties, respectively, allow the manufacture of a m-p or m-n Schottky diode;
- hybrid nanocomposites comprising metallic and semiconducting nanocrystals grafted with organic compounds with metallic, p-type or n-type charge carrier transport properties may form p-n, p-p, n-n, m-m, m-p, m-n intra-nanoparticle junctions, respectively; and
- hybrid nanocomposites wherein the organic compound comprises an isolating moiety may, taking account of the well-ordered SAM that may be obtained, may form p-i-n, p-i-p, n-i-n, m-i-m, m-i-p, m-i-n junctions.

### [Process of manufacture]

A second object of the invention is a process of manufacture of the nanocomposite material of the invention.

The nanocomposite material of the invention is easily accessible by conventional steps from the reactants, nanocrystals and organic compound, without need for specific equipment. The processing does not require high temperature, high vacuum or various lithographic steps. The nanocomposite material of the invention may thus be manufactured for low cost.

A process of manufacture of the hybrid nanocomposite material according to the invention comprises the steps consisting of :
- (i): providing electrically conducting inorganic elongated nanocrystals;
- (ii): contacting the nanocrystals with an electrically conducting organic compound, optionally in an appropriate solvent, under conditions appropriate for the grafting of the organic compound onto the nanocrystals;
- (iii): isolation of the grafted nanocrystals obtained from the reaction mixture; and
- (iv): purifying the composite if appropriate.

Preferably, the nanocrystals are provided in step (i) in form of a suspension in an appropriate solvent. Preferably, the nanocrystals are used as such, without any further treatment, and in particular without any surfactant. Indeed, the presence of any foreign compounds may hinder the grafting process itself as well as the formation of a crystalline self-assembled monolayer and thus lowers the achievable efficiency of the device.

The solvent, if any, is chosen according to the nature of the nanocrystal, however, generally apolar solvent such as chlorinated aromatic or aliphatic hydrocarbon, ether or similar. Particularly preferred are chlorobenzene, dichlorobenzene chloroform, dichloromethylene, dimethylformamide, tetrahydrofurane. But depending on the nature of nanoparticle and the molecule to be grafted, polar solvents such as methanol,ethanol, propanol ent acetone may also be appropriate.

Step (ii) of the process is preferably carried out under stirring. The reaction time depends essentially on the reactivity of the anchoring group involved and the nanocrystal material. The reaction is however most often completed within 1 to 48 hours, but morphological evolution of the grafted monolayer towards a crystalline organization can take several days.

According to a specific embodiment of the invention, the nanocrystal is grafted by organic compounds having different absorption spectra.

According to another embodiment of the invention, the nanocrystal is grafted by two organic compounds differing by their preferred charge carrier transport.

According to another embodiment of the invention, the nanocrystal is grafted by two organic compounds differing by their conducting and self-assembling properties.

According to another embodiment of the invention, the nanocrystal is grafted by two organic compounds differing by their conducting and liquide crystal properties.

In all cases, specific grafting of the different compounds is preferred.

The grafting of organic compounds to specific sites at the surface of the nanocrystals is however difficult since the surface most often lacks selectivity with regard to the compound. In such cases, the nanocrystal surface has first to be prepared to become selective. The following two embodiments allow for selective grafting of nanocrystals. They are explained for a p-type and n-type organic compounds co-grafted to the surface of an n-type inorganic semiconductor, but may also be applied to other type of compounds.

According to a first embodiment, grafting of a p-type organic compound on the nanocrystal surface was not completed, leaving the nanocrystal with a surface coverage of less than 100 %. If the coverage is still sufficient, a stable SAM may be formed. The incomplete SAM may then act in a second step as a template for the subsequent grafting of the n-type organic compound selectively to the nanocrystal surface.

According to a second embodiment, the nanocrystal is first grafted with the p-type organic compound to obtain a complete SAM on the surface (surface coverage of 100% of the nanocrystal). In the second step, the hybrid nanocomposite obtained is exposed to a solution containing a n-type semiconductor, where p-type organic compounds will be partially exchanged by p-type compounds, in particular at sites where the SAM is less stable, such as for example the end of the elongated nanocrystals.

The hybrid composite is isolated in step (iii) by conventional methods. If a solvent is used, the separation can be conveniently carried out by filtration and/or centrifugation and/or evaporation.

Apart from rinsing with the solvent, no separate purification is generally required.

The hybrid nanocomposite thus obtained is stable with time and may be stored in solution until use. Indeed, the electrostatic or covalent bonds linking the organic to the inorganic materials prohibit phase separation the nanocomposite in solution. The formation of a self assembled monolayer (SAM) may further contribute to stabilize the hybrid nanocomposite.

Since the elongated nanocrystals have a dimensional stability, the nanocomposites are also stable upon processing into thin films. Hybrid nanocomposites of the invention thus allow access to a variety of electro-optical and electrical switching devices that are stable with time.

### [Thin film]

Thin films with coaxial ambipolar conducting properties may be obtained by depositing the hybrid nanocomposite of the invention, either from solution eventually further containing formulation aids such as a polymer.

The hybrid nanocomposite of the invention may be processed into a thin film by standard solution methods such as spin coating, dipping or printing generally followed by a subsequent drying step.

The organization and orientation of the hybrid nanocrystals within the thin film can be controlled using different techniques, in particular the application of an electric field, i.e. constant or alternating electrical field), forming the thin film using Langmuir Blodgett techniques, slow film drying techniques using solvents with high boiling point.

The organisation and orientation of the nanocrystals within the nanocomposite can also be controlled by way of selective grafting of different organic compounds on specific places of the nanocrystals, such as the terminal ends or the side walls.

Grafting of different organic compounds may also be used to confer amphiphilic behavior to the nanocrystals. Further, varying the amount of molecules grafted on the surface allows the tuning of the interaction between the hybrid nanocomposite and thus the organisation of the grafted compounds with self-assembling and LC properties at the surface.

For some applications, it can be interesting to obtain thin films of nanocomposite with partial or complete detachment or separation between the organic and inorganic components. This can be obtained by using grafted compounds that will form only weak bonds with the surface of the elongated nanocrystals or eventually by additional annealing steps.

### [Solar cells]

A third aspect of the invention concerns solar cells comprising the composite according to the invention.

Advantageously, the hybrid nanocomposite according to the invention can be processed from the solution, and may even be printable.

A solar cell may in particular be manufactured using the following steps consisting of:
(a) coating of a patterned conducting transparent substrate, such as an ITO substrate with a conducting film, such as a PEDOT film ; the conducting film ensures efficient hole extraction from and injection into the organic part of the hybrid composite;
(b) coating a hybrid nanocomposite layer on top of the conducting layer;
(c) fixing electric contacts, typically aluminium, on top of the hybrid nanocomposite layer, for efficient electron extraction from and injection into the organic part of the hybrid composite.

Preferred solar cells are formed by a thin film of the hybrid nanocomposite coated onto a conducting substrate as photovoltaic active layer. Furthermore, by using a hybrid nanocomposite with internal n-p junctions, light absorption and exciton dissociation at the hybrid interface followed by ambipolar transport to the outer electrodes can be performed. In all cases, the organic compound has active photovoltaic role and/or lead to improved solubility, charge carrier injection and self assembling properties of the inorganic elongated nanocrystal.

In general, hybrid nanocomposite based on combination of metallic and semiconducting nanocrystals grafted with an organic compound with metallic, p-type or n-type charge carrier transport properties assembled with the following intra-nanoparticle junction according to the invention: p-n, p-p, n-n, m-m, m-p, m-n where m, n and p stand for organic or inorganic metallic, n-type and p-type semiconducting properties, respectively, have also charge separation properties and are thus useful as photovoltaic active materials for solar cells.

Furthermore, an isolating moiety introduced into the organic compound may, taking account of the well-ordered SAM that can be obtained, play the role of an isolating layer in conventional devices. Therefore, application of p-i-n, p-i-p, n-i-n, m-i-m, m-i-p, m-i-n junction nanocomposites, which allow a better separation of the electronic properties of each part of the hybrid nanocomposite, could lead to improved solar cell performances compared to the above mentioned hybrid nanocrystals.

Hybrid nanocomposites forming p-i-n, p-i-p, n-i-n, junctions can be useful as active layer for field effect transistors (FET).

### [Switchable devices]

A fourth aspect of the invention concerns switchable devices comprising the composite according to the invention.

A switchable device may be in particular, as the simplest case, a field effect transistor (FET) using the nanocomposite thin film as electrically active, i.e. charge transporting, layer. Furthermore, by using hybrid nanocomposite with internal n-p junctions, ambipolar transistors can be formed. In all cases, the organic compound has active electrical transport properties and/or leads to improved solubility, charge carrier injection and self assembling properties of the inorganic elongated nanocrystal.

Other types of charge carrier transport materials can be built in by varying the electronic character of the organic and inorganic materials. For example hybrid nanocomposite with internal (intra-particular) p-n, p-p, n-n, junctions can be used as active layer for FETs.

Furthermore, an isolating moiety introduced between the anchoring moiety and the conducting moiety, and taking account of the well-ordered SAM that may be obtained, such moiety may play the role of an isolating layer in conventional devices. Therefore, application of p-i-n, p-i-p, n-i-n junction nanocomposites, which allow a better separation of the electronic properties of each part of the hybrid nanocomposite, could lead to improved charge carrier transport in the hybrid FETs using the hybrid nanocomposite material.

The switchable devices may be manufactured from the hybrid nanocomposite material according to the invention using conventional methods wherein the coating of the hybrid nanocomposite is performed by spin coating or other solution processingtechniques on top of a treated or untreated SiO₂ substrate.

Further contemplated is the use of the hybrid nanocomposite according to the invention as a light emitting diode (LED) and as a nanosized power source.

The invention will now be described by way of example with reference to the following figures:

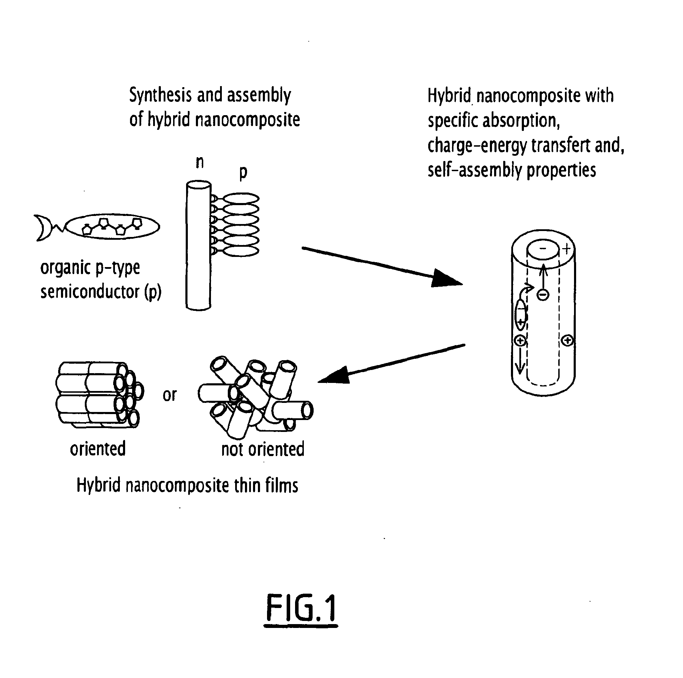

- Fig.1:: a schematic representation of assembly of a hybrid nanocomposite n-p junction according to a preferred embodiment of the invention;
- Fig.2:: (a) Electronic absorption spectrum of a (i) ZnO nanorods; (ii) the organic compound AO ; (iii) the hybrid nanocomposite according to example 1, all in THF solution; (b) Electronic absorption spectrum of a (i) ZnO nanorods; (ii) the organic compound ADO ; (iii) the hybrid nanocomposite according to example 2, all in THF solution;
- Fig.3:: Electronic absorption spectra of (A) :i) a solution of Ds2T (THF, concentration 8·10⁻⁸ mol), ii) of a thin film of the Ds2T on quartz substrate under H polarization, obtained by high vacuum evaporation, thickness 50 nm. (B) Electronic absorption spectra of i) a solution of the AO grafted nanorods (THF, concentration) and ii) a solution of the corresponding AO grafted spherical nanocrystals.
- Fig.4:: (A) Out of plane X-ray diffraction patterns of example 1 thin films and AO powder; (B) In-plane X-ray diffraction patterns of thin films of the hybrid nanocomposite of example 1 and of Ds2T deposited onto SiO₂ substrate at different temperature;
- Fig.5:: schematic representation of a solar cell prepared using the hybrid nanocomposite of the invention;
- Fig.6:: Current-voltage characteristics of solar cells containing the hybrid nanocomposite with 80-100 % surface coverage (black and red) or 50-70% surface coverage (green and blue) of the surface of ZnO nanorods of example 1 (AO-ZnO (A) and example 2 ADO-2nO (B) under illumination with an AMO 1.5 spectrum;

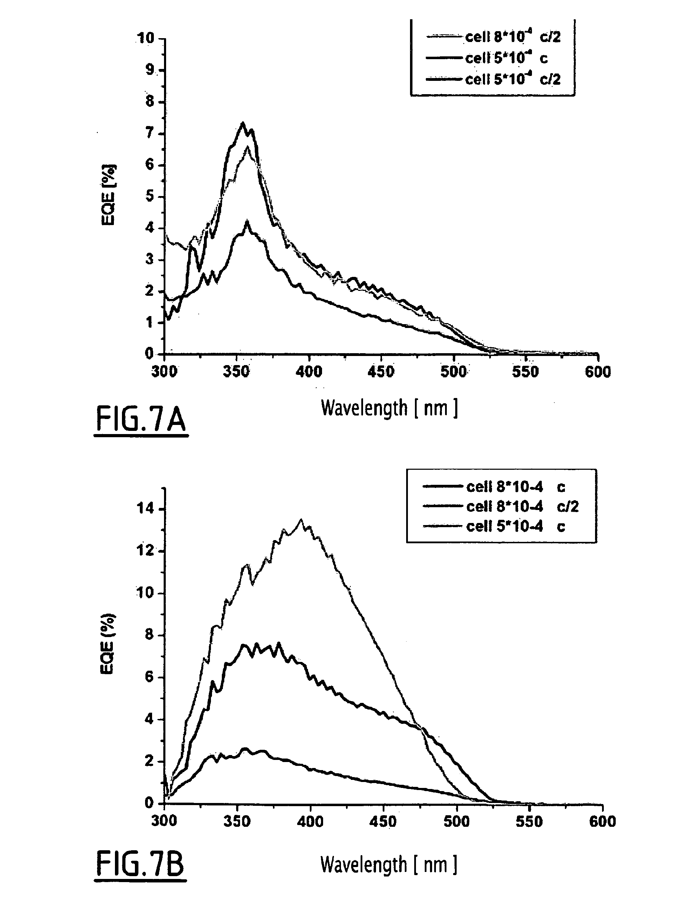

- Fig.7:: (a) External quantum efficiency as a function of the wavelength for solar cells containing the hybrid nanocomposite of example 1; the monolayer of the organic compound was almost completely (80-100 % surface coverage, black and green) or only partly (50-70% surface coverage, red) covering the surface of ZnO nanorods (b) External quantum efficiency as a function of the wavelength for solar cells containing the hybrid nanocomposite of example 2; the monolayer of the organic compound was almost completely ( 80-100 % surface coverage, black and red) or only partly (50-70% surface coverage, green) covering the surface of ZnO nanorods;
- Fig. 8:: Schema of the HFET fabricated by using hybrid nanocomposite thin films; and
- Fig.9:: (a) Hybrid field effect transistor: plot of *I*_{Ds} versus *V*_{DS} at various gate voltages in a hybrid nanocomposite thin film devices based on example, fabricated by spin coating (A) hole transporting regime, (B) electron transporting regime.

### [EXAMPLES]

### EXAMPLE 1 : Preparation of a hybrid nanocomposite with ZnO nanorods

### A. Preparation of ZnO nanorods

In a suitable flask, sodium hydroxyde (288,8 mg, 7,22 mmol) and methanol (23 mL) were sonicated until a fine dispersion is obtained. In a separate flask, zinc acetate (818,2 mg, 4,46 mmol), methanol (42 mL) and water (318 mL) were sonicated until completed dissolution and heated under stirring to 60°C. The sodium hydroxide solution was then added dropwise to the zinc acetate solution under argon atmosphere. After 2 h and 15 min at 60 °C, the growth solution was condensed to 10 mL under reduced pressure at 55 °C (the solution become colorless) and heated for 48 h at 60 °C. The decanted dispersion was transferred in a distillation flask and then methanol (50 mL) was added, the solution stirred for 5 min and allowed to decant, and the supernatant removed. This washing process was repeated 3 times.

ZnO nanorods were obtained with a mean diameter of 10 - 12 nm and a average length of 60 nm, as determined by transmission electron microscopy (TEM). The high resolution TEM (HRTEM) images reveal that the pure ZnO rods are monocristalline nanocrystals with remarkably flat faces at the atomic resolution.

Following the same chemical procedure, but without the last step of condensation and further growth, spherical ZnO nanoparticles with a diameter of 4 nm were obtained and used as a reference.

### B. Preparation of a hybrid nanocomposite

The nanorods obtained according to the preceding section were grafted with a semiconducting oligothiophene (AO) of the following formula :

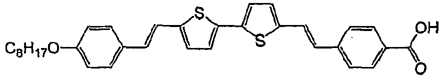

This nonsymmetrically substituted distyryl bithiophene derivative bearing a linear *n*-octyloxy chain in para position and a carboxylic acid function as terminal groups was synthesized according to the protocol given in the schema below.

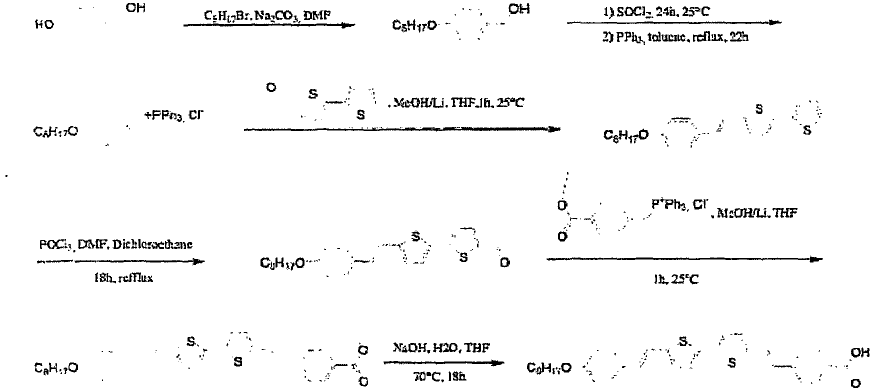

The nanorods were grafted with the semiconducting oligothiophene compound AO according to the following protocol. A highly concentrated solution of ZnO nanorods in methanol (50-70 mg/ml) was mixed with a solution of AO in tetrahydrofuran (THF) (typical ratio used is 10⁻⁷ Mol per mg ZnO nanorods) under stirring and the mixture was allowed to stand for 3 days at room temperature.

The functionalized nanorods were collected by centrifugation and washed several times with THF until the UV-VIS absorption spectrum of the surpernatant did not show any absorption in the transition bands of the AO chromophore. The results indicate a complete grafting up to concentration of 10⁻⁶ Mol per mg ZnO nanorods. This leads to a packing density of corresponding to the values given in the literature polycristalline films of Ds2T (see in C. Videlot-Ackermann, J. Ackermann, H. Brisset, K. Kawamura, N. Yoshimoto, P. Raynal, A. El Kassmi, F. Fages, J. Am. Chem. Soc. 127, 16346-16347 (2005)) . TEM did not show any modification in shape and size of the inorganic rods after functionalization.

### EXAMPLE 2 : Preparation of a hybrid nanocomposite with ZnO nanorods

The nanorods obtained according to Example 1 A were grafted with a semiconducting oligothiophene (ADO) of the following formula :

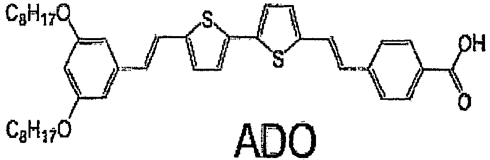

This compound differs from the compound AO in that the distyryl bithiophene bears twp linear n-octyloxy chains in meta position. The compound was synthesized according to the protocol For the synthesis of ADO and ATO, we used the same process as described for AO, starting, respectively, from the 3,5-dihydroxybenzyl alcohol and the 3,4,5-trihydroxylbenzyl alcohol.

The nanorods were grafted with the semiconducting oligothiophene compound ADO according to the following protocol. A highly concentrated solution of ZnO nanorods in methanol (50-70 mg/ml) was mixed with a solution of ADO in tetrahydrofuran (THF) (typical ratio used is 10⁻⁷ moles per mg ZnO nanorods) under stirring and the mixture was allowed to stand for 3 days at room temperature.

### Characterization of the hybrid nanocomposites

FT-IR spectroscopy provided experimental evidence of the adsorption of AO on nanorods by way of the carboxylate species. The spectrum of a solid sample of AO grafted nanorods showed two series of bands at 1580 - 1510 cm⁻¹ and 1380 - 1450 cm⁻¹ for the asymmetric and symmetric stretching modes of the carboxylate group, respectively, along with the complete loss of the sharp peak at 1686 cm⁻¹ corresponding to the free acid in KBr (T. Antoun, R. Brayner, S. Al Terary, F. Fiévet, M. Chehimi, A. Yassar, Eur. J. Inorg. Chem. 1275-1284 (2007)). This spectral inhomogeneity reflects a mixing of the different modes of binding of the carboxylate groups to ZnO (K. D. Dobson, A. J. McQuillan, Spectrochimica Acta Part A 55, 1395-1405 (1999)).

Different distances between surface neighbouring zinc atoms, depending on the faces of the nanocrystals, may enable both chelating and bridging carboxylate coordination modes. Moreover, using fluorescence emission spectroscopy, the presence of oxygen vacancies was observed as surface defects. These sites favour the monodentate coordination mode (K. D. Dobson, A. J. McQuillan, Spectrochimica Acta Part A 55, 1395-1405 (1999)). The methylene and methyl C-H stretch peak positions were found to agree well with those of the free acid in KBr and of a vacuum-evaporated thin film of the methyl ester of AO, AOMe, which is indicative of a crystalline organization of the n-octyl chains when the oligomers are bound to the metal oxide surface (D. L. Allara, R. G. Nuzzo, Langmuir 1, 52-66 (1985)).

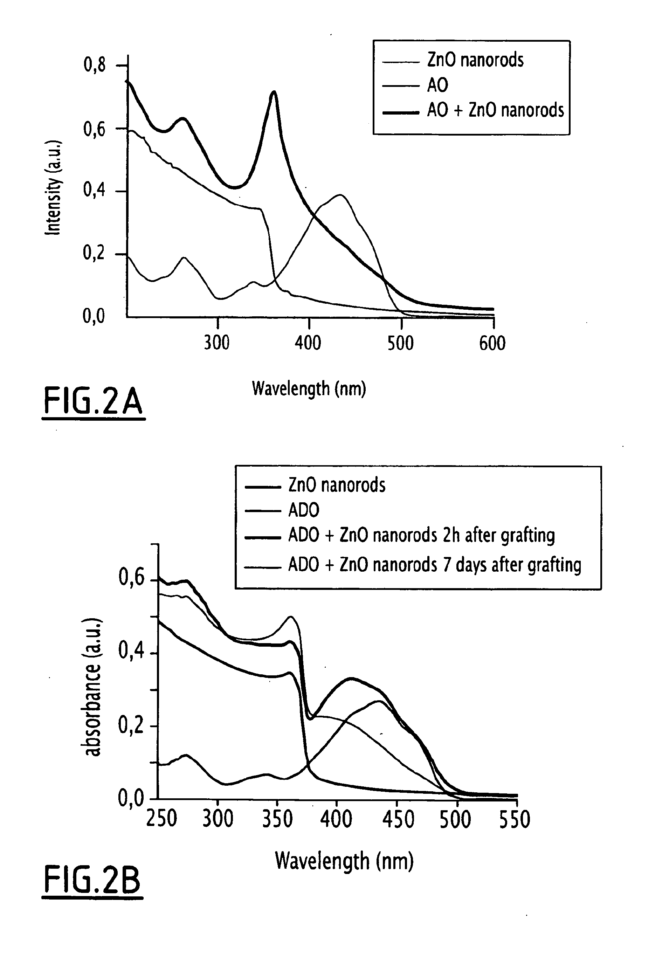

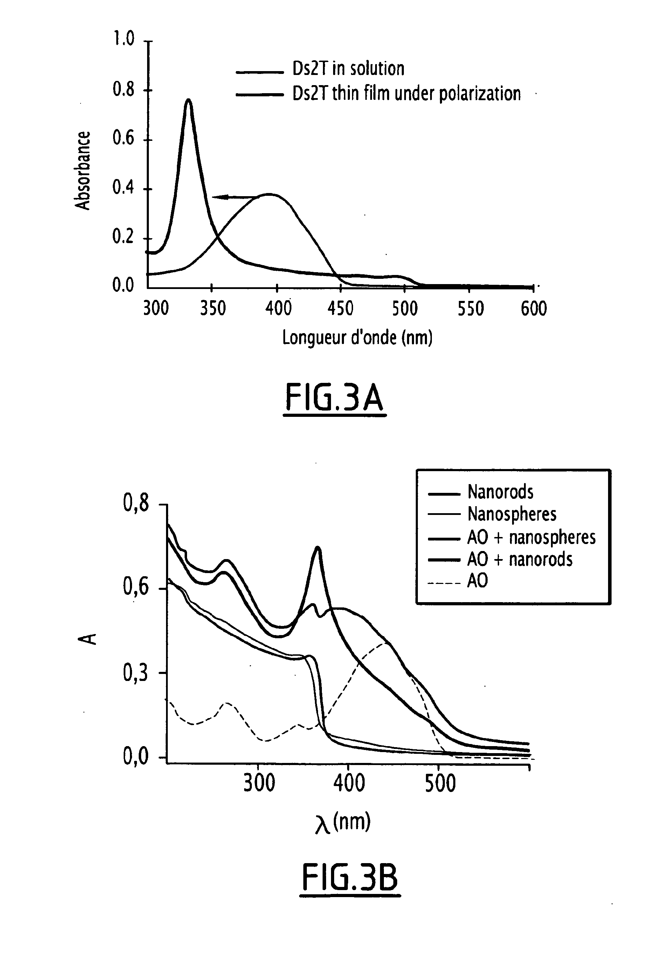

Electronic absorption spectroscopy provided insights into the organization of the ligand chromophores at the nanorod surface. The spectrum of a solution of AO grafted nanorods in THF exhibited a large blue shift and a marked sharpening of the oligothiophene lowest-energy transition band (λₘₐₓ= 368 nm) relative to that of AO in THF (λₘₐₓ= 465 nm) (Fig.2A). Actually, the spectrum of AO grafted nanorods much resembled that of a thin solid film of Ds2T (λₘₐₓ= 342 nm) (Fig.3A) obtained by high vacuum evaporation at a substrate temperature of 80 °C, that is under conditions where highly crystalline thin films are produced. The corresponding electronic absorption spectrum of a solution of ADO grafted nanorods in THF exhibited a completely different behavior. Figure 2B reveals that only weak blue shift and a very large absorption band are obtained in the case of ADO grafted nanorods even after several days after grafting.

When the compound AO is grafted on zinc oxide spherical nanoparticles instead of nanorods, a less shifted and broader spectrum was obtained (Fig.3B). the absorption band being centered at around 400 nm, which indicates a weaker exciton coupling for surface chromophores attached to a spherical crystals relative to rodlike particles. Due to their salient geometrical features, the zinc oxide nanorods promote the self-assembly of AO into a monolayer with a crystalline organization similar to that prevailing in thin films of related rigid conjugated systems.

The adsorption of molecules from the solution to the nanoparticles surface is a very fast process. Indeed, the characteristic hypo DS2T chromic shift of the H-aggregate signature is typically obtained within 1 hour after grafting. This step is followed by the ordering of the grafted molecules at the surface, similar to a crystallization process, leading to the final spectrum (Fig.2A). This is consistent with the known property of carboxylic acids form dynamic organic surface phases. Remarkably, this effect has also been observed under partial grafting conditions, that is for a density of surface functionalization of 50 %. This means that, at incomplete coverage, AO molecules are still capable to gather and self-organize into small crystalline domains at the nanorod surface.

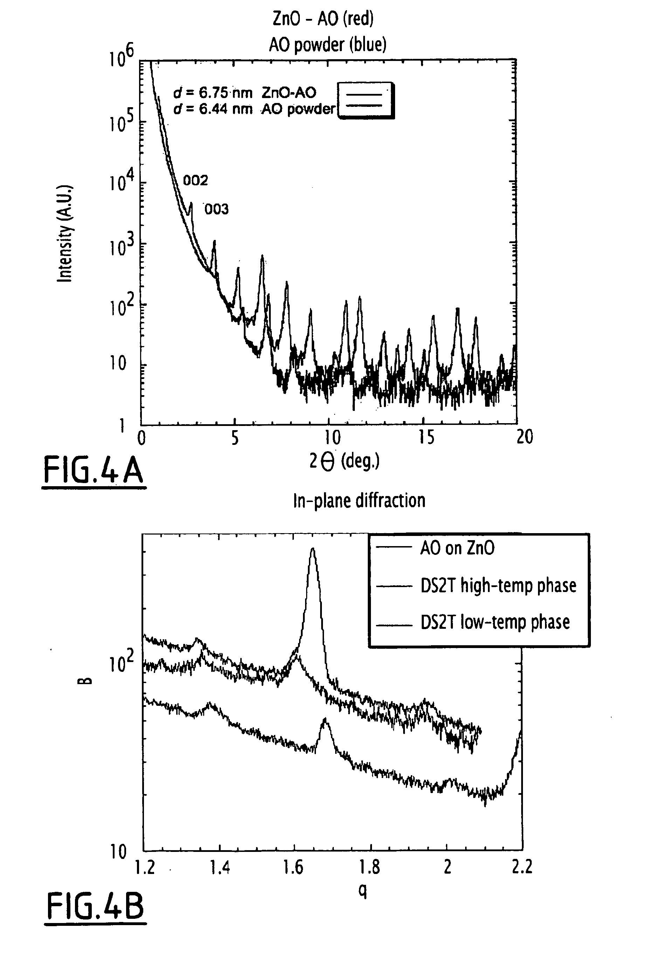

X-ray diffraction data on solution-deposited thin films of the hybrid nanocomposite confirmed the crystalline organization of the oligothiophene molecules at the surface of ZnO. The conventional out-of-plane *θ*/2*θ* scan pattern contains two size-broadened peaks at 2*θ*= 32° and 2*θ* = 36° corresponding to the (100) and (101) reflections of zincite ZnO (wurtzite structure). The (002) reflection is not observed in the out-of plane detection because the nanorods have a preferred orientation parallel to the substrate surface. At lower angle values, a series of sharp peaks, not observed in the diffraction pattern of the bare ZnO nanorods, indicates a lattice spacing 6.75 nm, which is attributed to the interparticle distance in the vertical stacking of hybrid nanocomposite in the film (see fig. 4A). This periodicity length is close to that determined from the diffractogram of a thin film of pure AO (lattice spacing 6.44 nm). It corresponds to almost twice that of the molecular length of AO. In the in-plane grazing incidence X-ray diffraction (GIXD) pattern of the hybrid nanocomposite, the two peaks at 2 *θ* = 32° and 2 *θ*= 36° are still observed, but, as expected, they are now accompanied by the strong and sharp peak at 2 *θ* = 35° corresponding to the (002) reflection of ZnO. Remarkably, at lower values of 2 *θ* shown in fig. 4B, the peaks match those observed for thin film of distyryl analogues (C. Videlot-Ackermann, J. Ackermann, K. Kawamura, N. Yoshimoto, H. Brisset, P. Raynal, A. El Kassmi, F. Fages, Org. Electron. 7, 465-473 (2006).) that form crystalline organisations. They can be attributed to the lattice spacing within the monolayer of AO molecules at the surface of ZnO.

These results indicate that the organic component of the hybrid nanocomposite of example 1 has a crystalline ordering, while the absence of such peaks for the nanocomposite of example 2 suggests that such an ordering is absent.

### Preparation of hybrid nanocomposite solar cells

Solar cells were manufactured from the hybrid nanocomposites prepared in examples 1 and 2 as follows.

An active layer of hybrid nanocomposite obtained in example 1 and 2 were coated onto a suitable conducting substrate (ITO on glass) coated beforehand with an appropriate hole conduction layer of PEDOT:PSS by spin coating [2000 rpm, drying at 120 °C under N₂]. After drying and annealing of the sample at 120 °C for 15 minutes, aluminium layer was evaporated on top of the active layer using evaporation masks to form the top contacts.

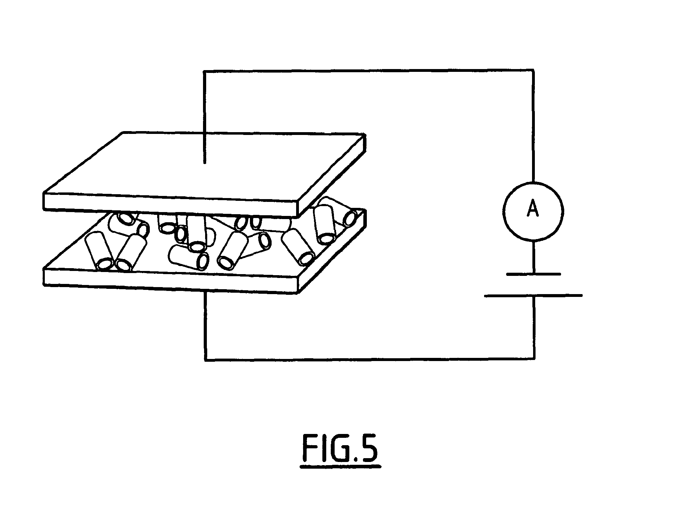

The performance of the solar cell obtained, schematically represented on Fig. 5, was characterized under a simulated solar spectrum AM1.5 of about 40 mW/cm².

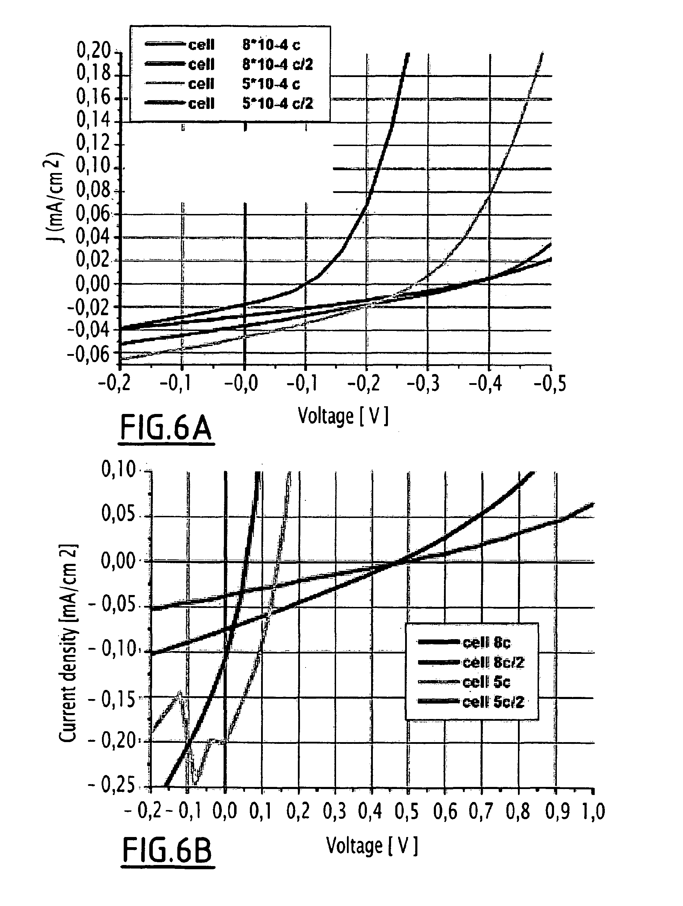

In both cases, the current / voltage curve is diode-like in absence of light while the response is photovoltaic under light with well pronounced open circuit voltages Voc and short circuit currents Isc (see Fig. 6A and 6B). This shows that the hybrid nanocomposites behave as p-n junction and are capable of exciton dissociation followed by hole and electron collection from the hybrid interface to the outer electrodes. Remarkably the highest photocurrent is obtained for both cell types for a surface coverage of only 70% of the hybrid nanocomposite instead of using a complete monolayer covered nanocomposite. This was attributed to better mechanical contact between the electron transporting nanorods as well as a higher amount of hybrid nanocomposites beeing oriented inside the thin film with their long axis perpendicular to the ITO substrate. This could be found it out of plane GIXD measurement using hybrid nanocomposite with varying surface coverage.

The external quantum efficiency (EQE) at the absorption maximum of the the solar cells using the hybrid nanocomposite of example 2 is around 14%, which is a very interesting photovoltaic response of such a device (see Fig. 7A and 7B).

### Preparation of hybrid nanocomposite transistors

Hybrid field effect transistors (HFET) were manufactured using the hybrid nanocomposite obtained from examples 1 and 2 as follows.

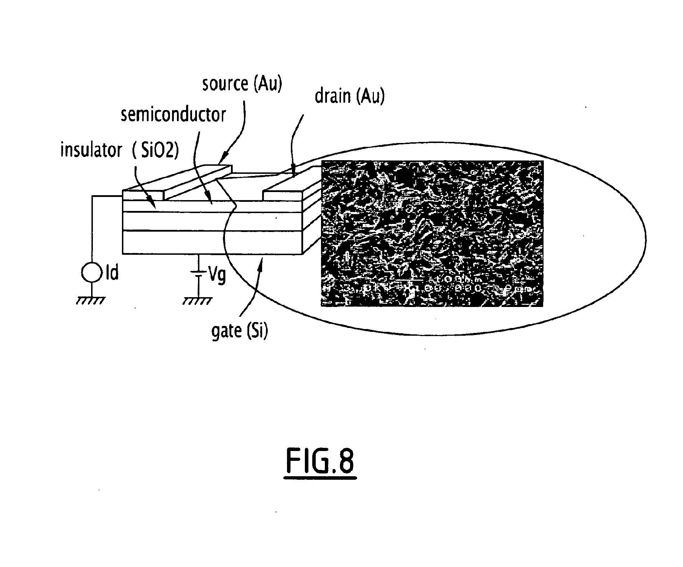

The nanocomposite was deposited by spin coating onto a SiO₂ coated Si substrate and gold source and drain contacts were subsequently deposited on top of the layer obtained. Figure 8 shows a schematic representation of the HFET.

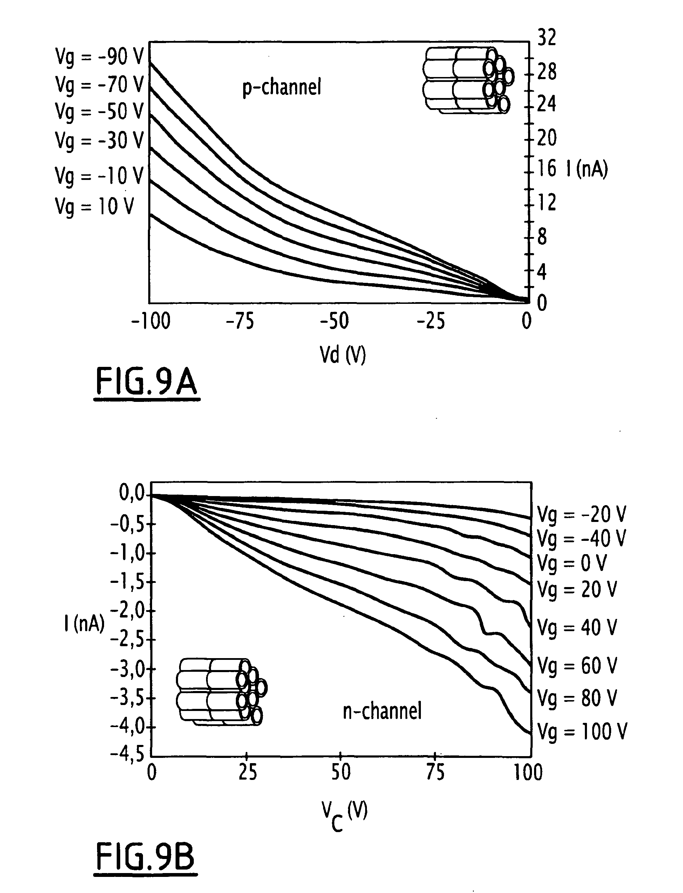

The HFETs thus obtained were electronically characterized under negative and positive gate bias voltage. Under negative grid bias voltage, the current rises along with the voltage (see Fig.9A). This shows that the active canal of the transistor possesses hole transport capacities.

At a positive grid voltage, a polarisation reversal is observed, again along with a rising voltage (see Fig. 9B). This indicates that the active layer of the transistor exhibits a field effect for the electron transport.

In conclusion, the active layer of the HFET, that is the hybrid nanocomposite of the invention, possesses the capacity of ambipolar charge carrier transport.

## Claims

1. A hybrid nanocomposite material comprising electrically conducting inorganic elongated nanocrystals grafted on at least part of the surface thereof with an electrically conducting organic compound, wherein the organic compound forms a self-assembled monolayer (SAM) and **characterised in that** the organic compound is a compound of formula (I):
A-L-Y-Z-X (I)
wherein :
A is an anchoring moiety, and is a carboxylic acid, an amine, a phosphonic acid, a phosphate, a thiol or a silane group ;
L is a non conducting moiety and is a saturated hydrocarbon group or may be absent;
Y is an electrically conducting moiety comprising a conjugated system selected from pentacene, anthracene, phthalocyanines, porphyrines, fullerenes, oligothiophenes, PEDOT, polypyrrol, chlorophylls, bacterio-chlorophylls and carotenoids;
Z is a solubilizing moiety and is an unconjugated hydrocarbon group selected from a straight or branched, saturated or unsaturated alkyl group with 1 to 20 carbon atoms, in particular n-butyl, n-pentyl, n-hexyl, n-heptyl and n-octyl, or may be absent; and
X is a stabilizing moiety capable of forming intermolecular bonds and may in particular be a group forming hydrogen bonds such as hydroxy, amino, amide or carboxylic acid, or may be absent.

2. Hybrid nanocomposite material according to claim 1, wherein the elongated nanocrystals are nanowires, nanorods, nanotubes, nanodipods, nanotripods, nanotetrapods or nanostars.

3. Hybrid nanocomposite material according to claim 1 or 2, wherein the elongated nanocrystals are metallic conductors.

4. Hybrid nanocomposite material according to any of claims 1 to 3, wherein the elongated nanocrystals are made of gold, silver, copper, or indium doped tin oxide.

5. Hybrid nanocomposite material according to any of claims 1 to 4, wherein the elongated nanocrystals are semiconductors.

6. Hybrid nanocomposite material according to any of claims 1 to 5, wherein the elongated nanocrystals are made of titanium, zirconium, hafnium, vanadium, niobium, tantalum, chromium, molybdenum, tungsten, manganese, technetium, rhenium, iron, osmium, cobalt, nickel, copper, silver, gold, zinc, cadmium, scandium, yttrium, lanthanum, boron, gallium, indium, arsenic, thallium, silicon, germanium, tin, lead, magnesium, calcium, strontium, barium and aluminum, and the simple or mixed chalcogenides, in particular oxides and sulfides, thereof.

7. Hybrid nanocomposite material according to any of claims 1 to 6, wherein the elongated nanocrystals are made of zinc oxide, zinc sulfide and titanium dioxide.

8. Hybrid nanocomposite material according to any of claims 1 to 7 comprising metallic nanocrystals grafted with an organic compound with p-type or n-type charge carrier transport properties, respectively.

9. Hybrid nanocomposite material according to any of claims 1 to 7, comprising metallic and semiconducting nanocrystals grafted with an organic compound with metallic, p-type or n-type charge carrier transport properties forming one or more of the following intra-nanoparticle junctions: p-n, p-p, n-n, m-m, m-p, m-n, where m, n and p stand for organic or inorganic metallic, n-type and p-type semiconducting properties.

10. Hybrid nanocomposite material according to any of claims 1 to 7, comprising metallic and semiconducting nanocrystals grafted with an organic compound with metallic, p-type or n-type charge carrier transport comprising an isolating moiety forming one or more of the following intra-nanoparticle junctions: p-i-n, p-i-p, n-i-n, m-i-m, m-i-p, m-i-n.

11. Hybrid nanocomposite according to any of claims 1 to 10, wherein the SAM comprises two organic compounds with different absorption spectra.

12. Hybrid nanocomposite according to any of claims 1 to 11, wherein the SAM comprises two organic compounds with different preferred charge carrier transport.

13. A process of manufacture of the material according to any of claims 1 to 12, comprising the steps consisting of :
(i) providing electrically conducting inorganic elongated nanocrystals;
(ii) contacting the nanocrystals with an electrically conducting organic compound, optionally in an appropriate solvent, under conditions appropriate for the grafting of the organic compound onto the nanocrystals;
(iii) isolation of the grafted nanocrystals obtained from the reaction mixture; and
(iv) purifying the composite if appropriate.

14. A thin film comprising the hybrid nanocomposite according to any of claims 1 to 12.

15. A solar cell comprising a semiconducting layer comprising the hybrid nanocomposite according to any of claims 1 to 12.

16. An electronic switching device comprising a semiconducting layer comprising the hybrid nanocomposite according to claims 1 to 12.

17. Electronic switching device according to claim 16, wherein the switching device is a p-n junction or a n-p junction.

18. Electronic switching device according to claim 16 or 17, wherein the switching device is a p-i-n junction.

## Patentansprüche

1. Ein Nanokomposit-Hybridmaterial, umfassend elektrisch leitende, anorganische, längliche Nanokristalle, die an mindestens einem Teil der Oberfläche mit einer elektrisch leitenden organischen Verbindung gepfropft sind, wobei die organische Verbindung eine selbst organisierende Monoschicht (SAM) bildet und **dadurch gekennzeichnet ist, dass** die organische Verbindung eine Verbindung der Formel (I) ist:
A-L-Y-Z-X (I)
wobei
A ein Verankerungsrest ist und eine Carbonsäure, ein Amin, eine Phosphonsäure, ein Phosphat, ein Thiol oder eine Silangruppe ist;
L ein nicht leitender Rest ist und eine gesättigte Kohlenwasserstoffgruppe ist oder abwesend sein kann;
Y ein elektrisch leitender Rest ist, umfassend ein konjugiertes System ausgewählt aus Pentacen, Anthracen, Phthalocyaninen, Porphyrinen, Fullerenen, Oligothiophenenen, PEDOT, Polypyrrol, Chlorophyllen, Bakteriochlorophyllen und Caratenoiden;
Z ein Solubilisierungsrest ist und eine unkonjugierte Kohlenwasserstoffgruppe ist ausgewählt aus einer linearen oder verzweigten, gesättigten oder ungesättigten Alkylgruppe mit 1 bis 20 Kohlenstoffatomen, insbesondere n-Butyl, n-Pentyl, n-Hexyl, n-Heptyl und n-Octyl, oder abwesend sein kann; und
X ein stabilisierender Rest ist, der imstande ist, intermolekulare Bindungen auszubilden und der insbesondere eine Gruppe sein kann, die Wasserstoffgruppenbindungen bildet, wie beispielsweise Hydroxy, Amino, Amide oder Carbonsäuren oder abwesend sein kann.

2. Nanokomposit-Hybridmaterial nach Anspruch 1, wobei die länglichen Nanokristalle Nanodrähte, Nanostäbe, Nanoröhren, Nanodipode, Nanotripode, Nanotetrapode oder Nanosterne sind.

3. Nanokomposit-Hybridmaterial nach Anspruch 1 oder 2, wobei die länglichen Nanokristalle metallische Leiter sind.

4. Nanokomposit-Hybridmaterial nach einem der Ansprüche 1 bis 3, wobei die länglichen Nanokristalle aus Gold, Silber, Kupfer oder Indium-dotiertem Zinnoxid hergestellt sind.

5. Nanokomposit-Hybridmaterial nach einem der Ansprüche 1 bis 4, wobei die länglichen Nanokristalle Halbleiter sind.

6. Nanokomposit-Hybridmaterial nach einem der Ansprüche 1 bis 5, wobei die länglichen Nanokristalle aus Titan, Zirconium, Hafnium, Vanadium, Niob, Tantal, Chrom, Molybdän, Wolfram, Mangan, Technetium, Rhenium, Eisen, Osmium, Kobalt, Nickel, Kupfer, Silber, Gold, Zink, Cadmium, Scandium, Yttrium, Lanthan, Boron, Gallium, Indium, Arsen, Thallium, Silizium, Germanium, Zinn, Blei, Magnesium, Calcium, Strontium, Barium und Aluminium und den einfachen oder gemischten Chalkogeniden, insbesondere Oxiden und Sulfiden, davon bestehen.

7. Nanokomposit-Hybridmaterial nach einem der Ansprüche 1 bis 6, wobei die länglichen Nanokristalle aus Zinkoxid, Zinksulfid und Titandioxid sind.

8. Nanokomposit-Hybridmaterial nach einem der Ansprüche 1 bis 7 umfassend metallische Nanokristalle gepfropft mit einer organischen Verbindung mit p-Typ bzw. n-Typ Ladungsträgertransportei genschaften.

9. Nanokomposit-Hybridmaterial nach einem der Ansprüche 1 bis 7 umfassend metallische und halbmetallische Nanokristalle gepfropft mit einer organischen Verbindung mit metallischen, p-Typ oder n-Typ Ladungsträgertransporteigenschaften, die einen oder mehrere der folgenden Kontakte innerhalb der Nanopartikel ausbilden: p-n, p-p, n-n, m-m, m-p, m-n, wobei m, n und p für organische oder anorganische, metallische, n-Typ und p-Typ halbleitende Eigenschaften stehen.

10. Nanokomposit-Hybridmaterial nach einem der Ansprüche 1 bis 7 umfassend metallische und halbleitende Nanokristalle gepfropft mit einer organischen Verbindung mit metallischem, p-Typ oder n-Typ Transportladungsträger, umfassend ein isolierender Rest, der eine oder mehrere der folgenden Kontakte innerhalb der Nanopartikel bildet: p-i-n, p-i-p, n-i-n, m-i-m, m-i-p, m-i-n.

11. Nanokomposit-Hybride nach einem der Ansprüche 1 bis 10, wobei das SAM zwei organische Verbindungen mit verschiedenen Absorptionsspektren umfasst.

12. Nanokomposit-Hybride nach einem der Ansprüche 1 bis 11, wobei das SAM zwei organische Verbindungen mit verschiedenen, bevorzugtem Ladungsträgertransport umfasst.

13. Ein Verfahren zur Herstellung des Materials nach einem der Anprüche 1 bis 12, umfassend die Schritte bestehend aus:
(i) Bereitstellen von elektrisch leitfähigen, anorganischen, länglichen Nanokristallen;
(ii) In Kontakt bringen der Nanokristalle mit einer elektrisch leitenden, organischen Verbindung, optional in einem geeigneten Lösungsmittel, unter Bedingungen, die für das Pfropfen der organischen Verbindung auf die Nanokristalle angemessen sind;
(iii) Isolierung der gepfropften Nanokristalle, die aus dem Reaktionsgemisch erhalten wurden; und
(iv) Aufreinigung des Komposits, falls angemessen.

14. Ein Dünnfilm, umfassend das Nanokomposit-Hybrid nach einem der Ansprüche 1 bis 12.

15. Eine Solarzelle, umfassend eine Halbleiterschicht, die das Nanokomposit-Hybrid nach einem der Ansprüche 1 bis 12 umfasst.

16. Ein elektronisches Schaltgerät, das eine halbleitende Schicht beinhaltet, umfassend das Nanokomposit-Hybrid nach den Ansprüchen 1 bis 12.

17. Elektronisches Schaltgerät nach Anspruch 16, wobei das Schaltgerät ein p-n Kontakt oder ein n-p Kontakt ist.

18. Elektronisches Schaltgerät nach Anspruch 16 oder 17, wobei das Schaltgerät ein p-i-n Kontakt ist.

## Revendications

1. Matériau nanocomposite hybride comprenant des nanocristaux allongés inorganiques électriquement conducteurs sur au moins une partie de la surface desquels est greffé un composé organique électriquement conducteur, dans lequel le composé organique forme une monocouche auto-assemblée (SAM), **caractérisé en ce que** le composé organique est un composé de formule (I) :
A-L-Y-Z-X (I)
dans laquelle :
A est un fragment d'ancrage, et est un groupe acide carboxylique, amine, acide phosphonique, phosphate, thiol, ou un groupe silane ;
L est un fragment non conducteur et est un groupe hydrocarboné saturé ou peut être absent ;
Y est un fragment électriquement conducteur comprenant un système conjugué choisi parmi le pentacène, l'anthracène, les phtalocyanines, les porphyrines, les fullerènes, les oligothiophènes, le PEDOT, le polypyrrol, les chlorophylles, les bactériochlorophylles et les caroténoïdes ;
Z est un fragment solubilisant et est un groupe hydrocarboné non conjugué choisi parmi les groupes alkyle linéaires ou ramifiés, saturés ou insaturés, ayant 1 à 20 atomes de carbone, en particulier n-butyle, n-pentyle, n-hexyle, n-heptyle et n-octyle, ou il peut être absent ; et
X est un fragment stabilisant capable de former des liaisons intermoléculaires et peut en particulier être un groupe formant des liaisons hydrogène tel qu'hydroxy, amino, amide ou acide carboxylique, ou il peut être absent.

2. Matériau nanocomposite hybride selon la revendication 1, dans lequel les nanocristaux allongés sont des nanofils, des nanobâtonnets, des nanotubes, des nanodipodes, des nanotripodes, des nanotétrapodes ou des nano-étoiles.

3. Matériau nanocomposite hybride selon la revendication 1 ou 2, dans lequel les nanocristaux allongés sont des conducteurs métalliques.

4. Matériau nanocomposite hybride selon l'une quelconque des revendications 1 à 3, dans lequel les cristaux allongés sont composés d'or, d'argent, de cuivre, ou d'oxyde d'étain dopé à l'indium.

5. Matériau nanocomposite hybride selon l'une quelconque des revendications 1 à 4, dans lequel les nanocristaux allongés sont des semi-conducteurs.

6. Matériau nanocomposite hybride selon l'une quelconque des revendications 1 à 5, dans lequel les nanocristaux allongés sont composés de titane, zirconium, hafnium, vanadium, niobium, tantale, chrome, molybdène, tungstène, manganèse, technétium, rhénium, fer, osmium, cobalt, nickel, cuivre, argent, or, zinc, cadmium, scandium, yttrium, lanthane, bore, gallium, indium, arsenic, thallium, silicium, germanium, étain, plomb, magnésium, calcium, strontium, baryum et aluminium, et leurs chalcogénures simples ou mixtes, en particulier leurs oxydes et sulfures.

7. Matériau nanocomposite hybride selon l'une quelconque des revendications 1 à 6, dans lequel les nanocristaux allongés sont composés d'oxyde de zinc, de sulfure de zinc et de dioxyde de titane.

8. Matériau nanocomposite hybride selon l'une quelconque des revendications 1 à 7, comprenant des nanocristaux métalliques greffés d'un composé organique ayant des propriétés de transport de support de charge de type p ou de type n respectivement.

9. Matériau nanocomposite hybride selon l'une quelconque des revendications 1 à 7, comprenant des nanocristaux métalliques et semi-conducteurs greffés d'un composé organique ayant des propriétés de transport de support de charge métallique, de type p ou de type n, formant une ou plusieurs des jonctions intra-nanoparticulaires suivantes : p-n, p-p, n-n, m-m, m-p, m-n, où m, n et p désignent des propriétés de semi-conducteur organique ou inorganique métallique, de type n, et de type p.

10. Matériau nanocomposite hybride selon l'une quelconque des revendications 1 à 7, comprenant des nanocristaux métalliques et semi-conducteurs greffés d'un composé organique ayant des propriétés de transport de support de charge métallique, de type p ou de type n, comprenant un fragment isolant formant une ou plusieurs des jonctions intra-nanoparticulaires suivantes : p-i-n, p-i-p, n-i-n, m-i-m, m-i-p, m-i-n.

11. Matériau nanocomposite hybride selon l'une quelconque des revendications 1 à 10, dans lequel la SAM comprend deux composés organiques ayant des spectres d'absorption différents.

12. Matériau nanocomposite hybride selon l'une quelconque des revendications 1 à 11, dans lequel la SAM comprend deux composés organiques ayant des propriétés de transport de support de charge préférées différentes.

13. Procédé de fabrication du matériau selon l'une quelconque des revendications 1 à 12, comprenant les étapes consistant à :
(i) disposer de nanocristaux allongés inorganiques électriquement conducteurs ;
(ii) mettre les nanocristaux en contact avec un composé organique électriquement conducteur, éventuellement dans un solvant approprié, dans des conditions appropriées pour le greffage du composé organique sur les nanocristaux ;
(iii) isoler les nanocristaux greffés obtenus à partir du mélange réactionnel ; et
(iv) purifier le composite si c'est approprié.

14. Film mince comprenant le nanocomposite hybride selon l'une quelconque des revendications 1 à 12.

15. Cellule solaire comprenant une couche semi-conductrice comprenant le nanocomposite hybride selon l'une quelconque des revendications 1 à 12.

16. Dispositif de commutation électronique comprenant une couche semi-conductrice comprenant le nanocomposite hybride selon l'une quelconque des revendications 1 à 12.

17. Dispositif de commutation électronique selon la revendication 16, lequel dispositif de commutation est une jonction p-n ou une jonction n-p.

18. Dispositif de commutation électronique selon la revendication 16 ou 17, lequel dispositif de commutation est une jonction p-i-n.
